# EUROPÄISCHE PATENTSCHRIFT

(11) **EP 1 852 901 B1**
(45) Veröffentlichungstag und Bekanntmachung des Hinweises auf die Patenterteilung: **19.05.2010**
(21) Anmeldenummer: 07008442.1
(22) Anmeldetag: 25.04.2007
(51) Int. Cl.: H01L 21/306

(54) **Verfahren zur Herstellung einer Schichtenstruktur**
Method for manufacturing a layered structure
Procédé de fabrication d'une structure stratifiée

(30) Priorität: 04.05.2006 DE 102006020825
(43) Veröffentlichungstag der Anmeldung: 07.11.2007
(73) Patentinhaber: Siltronic AG, 81737 München (DE)
(72) Erfinder: Feijóo, Diego, 84489 Burghausen (DE); Schwab, Günter, 84524 Neuötting (DE); Buschhardt, Thomas, 84489 Burghausen (DE)
(74) Vertreter: Staudacher, Wolfgang

(56) Entgegenhaltungen:
- WO-A-01/52309
- WO-A-02/33746
- US-A- 6 008 128
- US-A1- 2005 148 161

## Beschreibung

Gegenstand der Erfindung ist ein Verfahren zur Herstellung einer Schichtenstruktur mit einer geglätteten Zwischenschicht und einer auf der Zwischenschicht aufgebrachten, darüber liegenden Schicht. Derartige Schichtenstrukturen werden beispielsweise als Substrate für elektronische, optoelektronische und mikroelektromechanische Anwendungen hergestellt. Die Schichten werden beispielsweise mittels CVD-Verfahren auf einem Träger abgeschieden oder durch Bonding-Verfahren mit dem Träger verbunden. Vertreter solcher Substrate sind beispielsweise Halbleiterscheiben mit mehreren abgeschiedenen oder gebondeten Schichten, insbesondere SOI-Substrate (silicon on insulator), Substrate mit einer Schicht aus SiₓGe₁₋ₓ (Silizium-Germanium) und einer Schicht aus gespanntem Silizium (strained silicon on bulk) und sSOI-Substrate (strained silicon on insulator).

Das Aufbringen der darüber liegenden Schicht auf die Zwischenschicht stellt einen kritischen Schritt dar, weil er in der Regel zwingend erfordert, dass die Mikrorauhigkeit der Zwischenschicht möglichst niedrig ist. Es sind daher verschiedene Verfahren vorgeschlagen worden, um diesem Erfordernis gerecht zu werden. So wird gemäß der US2005/0104067 ein SGOI-Substrat (SiGe on insulator) vor dem Abscheiden einer Schicht aus gespanntem Silizium chemisch-mechanisch poliert, um die notwendige Glättung zu erreichen. Gemäß der US2003/0060020 wird mit einer magneto-rheologischen Flüssigkeit (MRF) poliert, um die Mikrorauigkeit weiter zu verringern. Nachteilig an diesen Verfahren ist der Aufwand, den sie erfordern. In der US6,995,077 ist ein Verfahren beschrieben, das speziell zur Glättung von Halbleiterscheiben aus einkristallinem Silizium vor dem Abscheiden einer epitaktischen Schicht dient und eine Behandlung der Halbleiterscheibe mit einem Gemisch aus Wasserstoff und Chlorwasserstoff umfasst. WO 01/52309 offenbart ein Verfahren zur Glättung von Substraten mit Hilfe von HF und Isopropanol.

Es bestand die Aufgabe, ein Verfahren der genannten Art vorzustellen, das weniger aufwändig ist als bekannte Verfahren und nicht nur zum Glätten von Oberflächen aus einkristallinem Silizium vor der Epitaxie geeignet ist.

Gegenstand der Erfindung ist ein Verfahren zur Herstellung einer Schichtenstruktur mit einer geglätteten Zwischenschicht gemäß Patentanspruch 1.

Das Verfahren lässt sich insbesondere auf Schichtenstrukturen anwenden, bei denen eine Zwischenschicht zu glätten ist, die aus einem Material besteht, das in einer Gruppe enthalten ist, zu der einkristallines Silizium, polykristallines Silizium, Silizium-Germanium, Germanium. Es eignet sich insbesondere zum Glätten von einkristallinen Halbleiterscheiben aus Silizium, auf denen eine epitaktische Schicht abzuscheiden ist, oder zum Glätten von dünnen Schichten aus einkristallinem Silizium, die nach einer Ionenimplantation von einer Donorscheibe abgetrennt und zur Bildung einer SOI-Scheibe auf eine Substratscheibe übertragen werden, oder zum Glätten eines "cross-hatch" auf sSOI-Substraten vor dem Abscheiden einer Schicht aus beispielsweise gespanntem Silizium, oder zum Glätten von Zwischenschichten oder ganzen Halbleiterscheiben aus polykristallinem Silizium, aus Siliziumcarbid oder aus Siliziumdioxid vor dem Bonden. Polykristallines Silizium wird isotrop geätzt, also unabhängig von der Orientierung der Kristallite geglättet. Die Rauigkeit von Zwischenschichten aus Siliziumdioxid, die durch thermische Oxidation von Silizium entstehen, ist in der Regel geringer, als die von Zwischenschichten aus Siliziumdioxid, die durch die Zersetzung von TEOS (Tetraethylorthosilikat) erzeugt wurden. Jedoch gehört nicht zum Gegenstand der Erfindung die Anwendung des Verfahrens zur Glättung solcher, auf Silikatbasis erzeugter Zwischenschichten.

Die Zwischenschicht wird mit einem gasförmigen Ätzmittel, das Fluorwasserstoff enthält, behandelt, um die glättende Wirkung zu erzielen. Zwischenschichten aus Silizium werden zuvor oder gleichzeitig oxidiert, damit der Fluorwasserstoff unter Bildung von Wasser die Oxidschicht auflösen und abtragen kann. Das Oxidationsmittel wird zusammen mit dem gasförmigen Ätzmittel zur Zwischenschicht geführt. Als Oxidationsmittel ist Ozon besonders bevorzugt.

Die glättende Behandlung der Zwischenschicht findet vorzugsweise in einer feuchten Umgebung, also in Gegenwart von zugeführtem Wasser statt. Beispielsweise wird Wasser auf die Zwischenschicht gesprüht, bevor das gasförmige Ätzmittel zugeführt wird. Das Oxidationsmittel oder das gasförmige Ätzmittel oder beide können mit Wasser angereichert werden, beispielsweise indem diese Stoffe durch Wasser geleitet werden, bevor sie zur Zwischenschicht gelangen. Anstelle reinen Wassers kann auch ozonhaltiges Wasser auf die Zwischenschicht gesprüht werden.

Das gasförmig zugeführte Ätzmittel kann neben Fluorwasserstoff und Oxidationsmittel auch einen oder mehrere weitere Stoffe enthalten, beispielsweise Stickstoff in der Funktion als Trägergas oder Wasserdampf. Es können auch Additive wie Isopropanol hinzugefügt werden, die die Benetzung der Oberfläche der Zwischenschicht verstärken. Ein für die glättende Behandlung der Zwischenschicht geeigneter Reaktor, ist beispielsweise in der US2004/0020513 A1 beschrieben.

Die glättende Behandlung der Zwischenschicht wird vorzugsweise bei einer Temperatur von 20 bis 70°C vorgenommen. Besonders bevorzugt ist ein Temperaturbereich von 30 bis 70 °C, weil bei darunter liegenden Temperaturen die Glättung zu langsam erfolgt und bei darüber liegenden Temperaturen keine glättende Wirkung zustande kommt, sondern die Rauigkeit der bearbeiteten Seite ansteigt. Optimal ist eine Temperatur im Bereich von 40 °C.

Die glättende Behandlung der Zwischenschicht wird vorzugsweise mehrmals, beispielsweise 1 bis 5 Mal, besonders bevorzugt 1 bis 2 Mal wiederholt. Es ist auch zweckmäßig, die Zwischenschicht nach jeder Wiederholung der glättenden Behandlung mit Wasser zu spülen.

Die Rauhigkeit der Zwischenschicht sinkt durch Anwendung des Verfahrens vorzugsweise auf weniger als 5 Å (0,5 nm) RMS, gemessen mit AFM auf einer Messfläche von 40 x 40 µm², besonders bevorzugt auf weniger als 2 Å (0,2 nm) RMS. Der durch die glättende Behandlung der Zwischenschicht erzielte Materialabtrag beträgt vorzugsweise nicht mehr als 0,5 µm, besonders bevorzugt 0,1 bis 0,2 µm.

Im Anschluss an die glättende Behandlung wird eine weitere Schicht auf die Zwischenschicht aufgebracht. Dies geschieht beispielsweise durch Abscheiden, insbesondere CVD-Abscheidung, oder Bonden.

### Beispiel:

Auf einem 300mm Silizium-Substrat wird epitaktisch eine 4µm dicke SiGe Schicht abgeschieden, wobei die Konzentration des Germaniums von 0 bis 20% über die Dicke der Schicht erhöht wird. Die Rauigkeit der Schicht zeigt einen RMS-Wert von 100 Å (10 nm) bei AFM-Messung mit einem Feld von 40 x 40 µm². Anschließend wird das epitaxierte Substrat durch Behandlung mit dem beschriebenen Verfahren geglättet. Dafür wird es in einer Ätzkammer bei 40°C mit Wasser besprüht und anschließend mittels HF-Gas und Ozon geätzt. Nach zweifacher Behandlung mit diesem Zyklus wird das Substrat wieder mit Wasser besprüht und trockengeschleudert. Dabei wird von der SiGe-Schicht insgesamt 0,2 µm abgetragen. Die AFM-Messung mit einem Feld von 40 x 40 µm² zeigt eine Verbesserung der RMS-Rauigkeit auf 3 Å (0,3 nm).

## Patentansprüche

1. Verfahren zur Herstellung einer Schichtenstruktur mit einer geglätteten Zwischenschicht aus einkristallinem Silizium, polykristallinem Silizium, Silizium-Germanium oder Germanium und einer auf der Zwischenschicht aufgebrachten, darüber liegenden Schicht, **dadurch gekennzeichnet, dass** die Zwischenschicht bei einer Temperatur von 20 bis 70°C mit einem gasförmigen Ätzmittel, das Fluorwasserstoff enthält, in Gegenwart eines Oxidationsmittels behandelt wird, wobei ein Materialabtrag von nicht mehr als 0,5 µm erzielt und die Zwischenschicht geglättet wird.

2. Verfahren nach Anspruch 1, **dadurch gekennzeichnet, dass** das gasförmige Ätzmittel das Oxidationsmittel enthält.

3. Verfahren nach Anspruch 1 oder Anspruch 2, **dadurch gekennzeichnet, dass** das gasförmige Ätzmittel Isopropanol enthält.

4. Verfahren nach einem der Ansprüche 1 bis 3, **dadurch gekennzeichnet, dass** das gasförmige Ätzmittel Wasser enthält.

5. Verfahren nach einem der Ansprüche 1 bis 4, **dadurch gekennzeichnet, dass** die Zwischenschicht auf eine Rauigkeit von kleiner als 5 Å (0,5 nm) RMS geglättet wird.

6. Verfahren nach einem der Ansprüche 1 bis 5, **dadurch gekennzeichnet, dass** die darüber liegende Schicht auf die Zwischenschicht gebondet wird.

7. Verfahren nach einem der Ansprüche 1 bis 5, **dadurch gekennzeichnet, dass** die darüber liegende Schicht auf der Zwischenschicht abgeschieden wird.

## Claims

1. Method for producing a layer structure comprising a smoothed interlayer composed of monocrystalline silicon, polycrystalline silicon, silicon-germanium or germanium, and an overlying layer applied on the interlayer, **characterized in that** the interlayer is treated in the presence of an oxidizing agent at a temperature of 20 to 70°C with a gaseous etchant containing hydrogen fluoride, a material removal of no more than 0.5 µm being obtained and the interlayer being smoothed.

2. Method according to Claim 1, **characterized in that** the gaseous etchant contains the oxidizing agent.

3. Method according to Claim 1 or Claim 2, **characterized in that** the gaseous etchant contains isopropanol.

4. Method according to one of Claims 1 to 3, **characterized in that** the gaseous etchant contains water.

5. Method according to one of Claims 1 to 4, **characterized in that** the interlayer is smoothed to a roughness of less than 5 Å (0.5 nm) RMS.

6. Method according to one of Claims 1 to 5, **characterized in that** the overlying layer is bonded onto the interlayer.

7. Method according to one of Claims 1 to 5, **characterized in that** the overlying layer is deposited onto the interlayer.

## Revendications

1. Procédé pour la fabrication d'une structure stratifiée comportant une couche intermédiaire lissée à base de silicium monocristallin, silicium polycristallin, silicium-germanium ou germanium et une couche sus-jacente appliquée sur la couche intermédiaire, **caractérisé en ce que** la couche intermédiaire est traitée à une température de 20 à 70 °C par un décapant gazeux qui contient de l'acide fluorhydrique, en présence d'un oxydant, de sorte qu'on obtient un enlèvement de matière n'excédant pas 0,5 µm et la couche intermédiaire est lissée.

2. Procédé selon la revendication 1, **caractérisé en ce que** le décapant gazeux contient un oxydant.

3. Procédé selon la revendication 1 ou la revendication 2, **caractérisé en ce que** le décapant gazeux contient de l'isopropanol.

4. Procédé selon l'une quelconque des revendications 1 à 3, **caractérisé en ce que** le décapant gazeux contient de l'eau.

5. Procédé selon l'une quelconque des revendications 1 à 4, **caractérisé en ce que** la couche intermédiaire est lissée jusqu'à une rugosité de moins de 5 Å (0,5 nm) RMS (en moyenne quadratique).

6. Procédé selon l'une quelconque des revendications 1 à 5, **caractérisé en ce que** la couche sus-jacente est fixée sur la couche intermédiaire.

7. Procédé selon l'une quelconque des revendications 1 à 5, **caractérisé en ce que** la couche sus-jacente est déposée sur la couche intermédiaire.
